# EUROPÄISCHE PATENTANMELDUNG

(11) **EP 1 326 082 A1**
(43) Veröffentlichungstag der Anmeldung: **09.07.2003**
(21) Anmeldenummer: 01130849.1
(22) Anmeldetag: 27.12.2001
(51) Int. Cl.: G01R 31/3185, G11C 29/00

(54) **Integrierte Schaltung mit konfigurierbarem Abtastpfad**

(71) Anmelder: Infineon Technologies AG, 81669 München (DE)
(72) Erfinder: Huch, Martin, Dr., 81739 München (DE); Kock, Ernst-Josef, Dr., 85614 Kirchseeon (DE); Mammitzsch, Jürgen, 82131 Gauting (DE); Wagner, Wolfgang, 81539 München (DE); Sulzer, Hans, 85435 Erding (DE)
(74) Vertreter: Jannig, Peter, Dipl.-Ing.

(57) **Zusammenfassung**

Die beschriebene integrierte Schaltung zeichnet sich dadurch aus, daß in ihr enthaltene Flip-Flops, welche im normalen Betrieb der integrierten Schaltung nicht in Reihe geschaltet sind, auf Veranlassung durch die integrierte Schaltung in Reihe schaltbar sind, und/oder daß in ihr enthaltene Flip-Flops zu einem oder mehreren Ringen verschaltbar sind. Dadurch ist es möglich, den Aufwand zur Durchführung der Burn-In-Prozedur zu reduzieren.

## Beschreibung

Die vorliegende Erfindung betrifft eine Vorrichtung gemäß dem Oberbegriff der Patentansprüche 1 und 5, d.h. eine integrierte Schaltung.

Integrierte Schaltungen sind seit vielen Jahren in unzähligen Ausführungsformen bekannt und bedürfen keiner näheren Erläuterung.

Ein bekanntes Problem von integrierten Schaltungen besteht darin, daß es sehr aufwendig ist, diese nach der Herstellung derselben umfassend zu testen.

Zu den Tests, die unbedingt durchgeführt werden müssen, gehört unter anderem der sogenannte Burn-In-Test.

Beim Burn-In-Test wird die zu testende integrierte Schaltung zunächst einer Burn-In-Prozedur unterzogen, und anschließend auf ihre ordnungsgemäße Funktion hin getestet.

Bei der Burn-In-Prozedur wird die integrierte Schaltung so betrieben, daß möglichst alle schaltbaren Elemente der integrierten Schaltung möglichst viele Schaltvorgänge durchführen. Der Vollständigkeit halber sei angemerkt, daß die Burn-In-Prozedur vorzugsweise in einer in einer auf eine hohe Temperatur aufgeheizte Kammer, sowie unter Verwendung einer erhöhten Versorgungsspannung durchgeführt wird.

Zum Betreiben der integrierten Schaltung während der Burn-In-Prozedur existieren zwei Möglichkeiten.

Die erste Möglichkeit besteht darin, daß eine in der integrierten Schaltung enthaltene Steuereinrichtung, welches beispielsweise die CPU einer programmgesteuerten Einheit, oder eine state machine einer sonstigen synchronen digitalen Schaltung sein kann, die einzelnen Komponenten der integrierten Schaltung so ansteuert, daß möglichst viele Schaltvorgänge stattfinden.

Die zweite Möglichkeit besteht darin, daß die integrierte Schaltung in einen Zustand versetzt wird, in welchem die Flip-Flops der integrierten Schaltung zu einer oder mehreren Scan-Ketten verschaltet werden, und durch die Scan-Ketten fest vorgegebene oder durch einen Zufallsgenerator generierte Datenfolgen geschoben werden.

Durch die erste Möglichkeit können bestimmte Komponenten der integrierten Schaltung wie insbesondere in der integrierten Schaltung enthaltene Speicher sehr gut so betrieben werden, wie es für die Burn-In-Prozedur wünschenswert ist. Nahezu alle anderen Komponenten der integrierten Schaltung können hierdurch jedoch nicht oder nur mit sehr großem Aufwand so betrieben werden, wie es für die Burn-In-Prozedur wünschenswert ist.

Diese anderen Komponenten können besser durch die zweite Möglichkeit so betrieben werden, wie es für die Burn-In-Prozedur wünschenswert ist. Andererseits können durch die zweite Möglichkeit die in der integrierten Schaltung enthaltenen Speicher nicht oder allenfalls mit unverhältnismäßig großem Aufwand so betrieben werden, wie es für die Burn-In-Prozedur wünschenswert ist.

Infolge dessen wird eine zu testende integrierte Schaltung während der Burn-In-Prozedur am besten aufeinanderfolgend oder abwechselnd nach der ersten Möglichkeit und nach der zweiten Möglichkeit betrieben.

Dies ist jedoch mit einem sehr großen Aufwand verbunden. Insbesondere die Inbetriebnahme der integrierten Schaltung nach der zweiten Möglichkeit ist relativ aufwendig, weil hierfür bekanntlich ein externes Testgerät und eine Vielzahl von elektrischen Verbindungen zwischen dem externen Testgerät und der zu testenden integrierten Schaltung vorzusehen ist, was insbesondere dann, wenn gleichzeitig sehr viele integrierte Schaltungen der Burn-In-Prozedur unterzogen werden sollen, problematisch ist.

Der vorliegenden Erfindung liegt daher die Aufgabe zugrunde, eine Möglichkeit zu finden, durch welche sich der zur Durchführung der Burn-In-Prozedur zu treibende Aufwand reduzieren läßt.

Diese Aufgabe wird erfindungsgemäß durch die in Patentanspruch 1 beanspruchte integrierte Schaltung und/oder durch die in Patentanspruch 5 beanspruchte integrierte Schaltung gelöst.

Die erfindungsgemäße integrierte Schaltung zeichnet sich dadurch aus,
- daß in der integrierten Schaltung enthaltene Flip-Flops, welche im normalen Betrieb der integrierten Schaltung nicht in Reihe geschaltet sind, auf Veranlassung durch die integrierte Schaltung in Reihe schaltbar sind, bzw.
- daß in der integrierten Schaltung enthaltene Flip-Flops zu einem oder mehreren Ringen verschaltbar sind.

Bei der erstgenannten integrierten Schaltung entfällt die Notwendigkeit, die genannte Verschaltung der Flip-Flops, also beispielsweise die Verschaltung der Flip-Flops zu Flip-Flop-Ketten oder Flip-Flop-Ringen von außerhalb der integrierten Schaltung zu veranlassen; bei der zweitgenannten integrierten Schaltung kann auf einen Zufallsgenerator verzichtet werden.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: eine integrierte Schaltung, deren Flip-Flops zu mehreren Flip-Flop-Ketten verschaltet sind,
- Figur 2: eine integrierte Schaltung, deren Flip-Flops zu mehreren Flip-Flop-Ringen verschaltet sind, und
- Figur 3: eine integrierte Schaltung, deren Flip-Flops zu mehreren Flip-Flop-Ketten verschaltet sind, welche teilweise auch noch weitere Elemente enthalten.

Die im folgenden beschriebene integrierte Schaltung ist eine programmgesteuerte Einheit wie beispielsweise ein Mikrocontroller, ein Mikroprozessor, oder ein Signalprozessor. Es sei jedoch bereits an dieser Stelle darauf hingewiesen, daß sich die im folgenden beschriebenen Besonderheiten der vorliegend betrachteten integrierten Schaltung auch bei beliebigen anderen synchronen digitalen Schaltungen einsetzen lassen.

Die betrachtete programmgesteuerte Einheit enthält einen vorzugsweise durch ein ROM gebildeten nichtflüchtigen Speicher, in welchem die Testprogramme gespeichert sind, die während der Tests auszuführen sind, welchen die programmgesteuerte Einheit nach der Herstellung derselben zu unterziehen ist. Unter diesen Programmen befindet sich auch ein Programm, welches während der Burn-In-Prozedur auszuführen ist; dieses Programm wird nachfolgend als Burn-In-Programm bezeichnet. Ob nach der Inbetriebnahme der programmgesteuerten Einheit eines der Testprogramme ausgeführt wird, und welches der Testprogramme gegebenenfalls ausgeführt wird, kann von außerhalb der programmgesteuerten Einheit oder durch die programmgesteuerte Einheit selbst bestimmt werden.

Ob nach der Inbetriebnahme der programmgesteuerten Einheit eines der Testprogramme ausgeführt wird, und welches der Testprogramme gegebenenfalls ausgeführt wird, kann beispielsweise festgelegt werden, indem
- bestimmte Pins oder Pads der programmgesteuerten Einheit miteinander verbunden werden, und/oder
- bestimmte Pins oder Pads der programmgesteuerten Einheit mit bestimmten Potentialen beaufschlagt werden, und/oder
- den verschiedenen Testprogrammen zugeordnete Fuses nach der Absolvierung des jeweiligen Tests durchgebrannt werden, und/oder
- den verschiedenen Testprogrammen zugeordnete Speicherzellen eines in der programmgesteuerten Einheit vorhandenen nichtflüchtigen Speichers nach der Absolvierung des jeweiligen Tests umprogrammiert werden, und/oder
- bestimmte Register oder Teile von Registern der programmgesteuerten Einheit (beispielsweise über eine serielle Schnittstelle wie etwa ein JTAG-Interface) von außerhalb der programmgesteuerten Einheit beschrieben werden.

Wenn die programmgesteuerte Einheit während der Burn-In-Prozedur in Betrieb genommen wird, beginnt sie mit der Ausführung des Burn-In-Programmes.

Das Burn-In-Programm steuert zunächst ausgewählte oder alle Komponenten der programmgesteuerten Einheit so an, daß möglichst viele (im Idealfall alle) Transistoren möglichst häufig schalten. Insbesondere führt es wiederholt Lese- und Schreibzugriffe auf die in der programmgesteuerten Einheit vorhandenen Speichereinrichtungen durch.

Im Anschluß daran veranlaßt das Burn-In-Programm eine Reihe von Schaltvorgängen, durch welche
- in der programmgesteuerten Einheit enthaltene Flip-Flops, welche im normalen Betrieb der programmgesteuerten Einheit nicht in Reihe geschaltet sind, in Reihe geschaltet werden, wodurch in der programmgesteuerten Einheit eine oder mehrere Flip-Flop-Ketten und/oder eine oder mehrere Flip-Flop-Ringe gebildet werden, und
- gegebenenfalls weitere Operationen durchgeführt werden, die später noch genauer beschrieben werden.

Die Veranlassung der besagten Schaltvorgänge kann beispielsweise dadurch erfolgen, daß ein oder mehrere Bits in einem Register gesetzt werden, von deren Inhalt es abhängt, welchen Zustand die die Schaltvorgänge durchführenden Schalter einnehmen. Vorzugsweise werden mehrere Bits verwendet, weil dadurch die Wahrscheinlichkeit reduziert wird, daß im normalen Betrieb der programmgesteuerten Einheit unbeabsichtigt Flip-Flop-Ketten oder Flip-Flop-Ringe gebildet werden. Es könnte auch vorgesehen werden, daß das betreffende Bit oder die betreffenden Bits nur gesetzt werden können, wenn sich die programmgesteuerte Einheit in einer bestimmten Betriebsart befindet, wobei diese Betriebsart nicht die normale Betriebsart der programmgesteuerten Einheit ist.

Zur Vermeidung von Mißverständnissen sei angemerkt, daß von den in Reihe geschalteten Flip-Flops der Ausgangsanschluß eines jeweiligen Flip-Flops jeweils mit dem Eingangsanschluß des in der Reihe nach ihm angeordneten Flip-Flops verbunden ist, und daß der Eingangsanschluß eines jeweiligen Flip-Flops jeweils mit dem Ausgangsanschluß des in der Reihe vor ihm angeordneten Flip-Flops verbunden ist.

Darüber hinaus ist es so, daß mit den Ausgangsanschlüssen der Flip-Flops auch noch weitere Elemente der programmgesteuerten Einheit verbunden sind; zum Verschalten der Flip-Flops zu Flip-Flop-Ketten oder Flip-Flop-Ringen werden den Flip-Flops nämlich lediglich andere Eingangssignale zugeführt als im normalen Betrieb, nämlich anstelle der den Flip-Flops normalerweise zugeführten Eingangssignalen die Ausgangssignale der in der Reihe jeweils vor ihnen stehenden Flip-Flops. Dies ist durch den Eingangsanschlüssen der Flip-Flops vorgeschaltete, in den Figuren nicht gezeigte Umschalter möglich, welche bei der Bildung der Flip-Flop-Ketten oder Flip-Flop-Ringe durch das Burn-In-Programm betätigt werden. Die erwähnten weiteren Elemente, mit welchen die Ausgangsanschlüsse der Flip-Flops verbunden sind, sind im allgemeinen größtenteils logische Gatter, können aber auch sonstige digitale oder analoge Schaltungskomponenten wie Komparatoren, Schmitt-Trigger, Treiber etc. umfassen.

Die zu Flip-Flop-Ketten oder Flip-Flop-Ringen verschalteten Flip-Flops umfassen vorzugsweise alle Flip-Flops der programmgesteuerten Einheit.

Der Vollständigkeit halber sei angemerkt, daß die Ausführung des Burn-In-Programmes endet mit der Verschaltung der Flip-Flops der programmgesteuerten Einheit zu Flip-Flop-Ketten oder Flip-Flop-Ringen endet. Der Grund hierfür liegt darin, daß die das Burn-In-Programm ausführende Komponente der programmgesteuerten Einheit, also die CPU derselben, und übrigens auch die meisten anderen Komponenten der programmgesteuerten Einheit durch die Verschaltung der darin enthaltenen Flip-Flops zu Flip-Flop-Ketten oder Flip-Flop-Ringen nicht mehr so arbeiten können wie sie es im normalen Betrieb der programmgesteuerten Einheit tun. Folglich müssen von diesem Zeitpunkt an alle Operationen, die nicht automatisch ablaufen, von außerhalb der programmgesteuerten Einheit veranlaßt werden. Zu den Operationen, die nicht von außerhalb der programmgesteuerten Einheit veranlaßt werden müssen, gehören vorzugsweise zumindest das später noch genauer beschriebene fortlaufende Weiterschieben der in den Flip-Flops enthaltenen Daten nach der Verschaltung derselben zu Flip-Flop-Ketten bzw. Flip-Flop-Ringen, sowie Operationen, welche das Burn-In-Programm noch vor dem Verschalten der Flip-Flops zu Flip-Flop-Ketten bzw. Flip-Flop-Ringen veranlassen konnte.

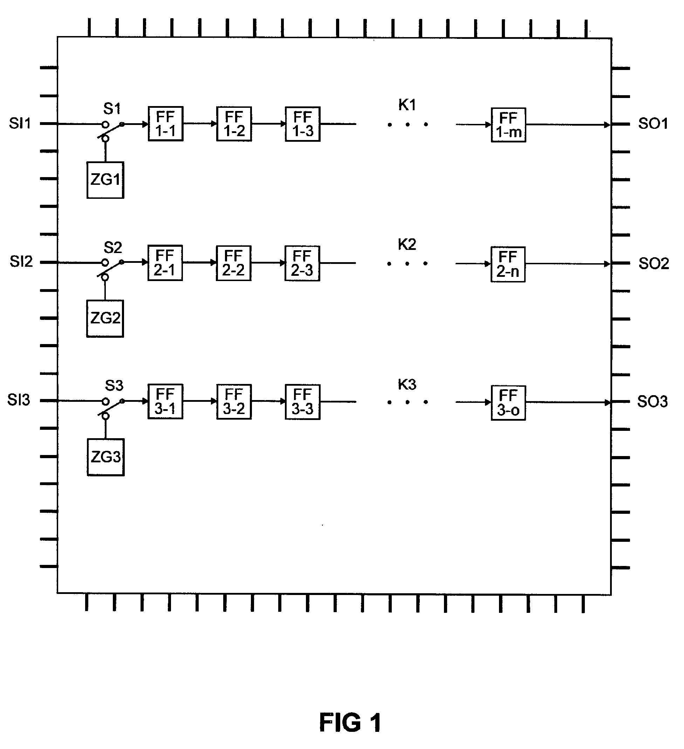

Eine programmgesteuerte Einheit deren Flip-Flops zu drei Flip-Flop-Ketten verschaltet sind, ist in Figur 1 dargestellt. Der Vollständigkeit halber sei bereits an dieser Stelle darauf hingewiesen, daß auf die Zahl drei keine Einschränkung besteht; prinzipiell kann die Anzahl der gebildeten Flip-Flop-Ketten auch beliebige andere Werte annehmen.

Die Flip-Flop-Ketten der in der Figur 1 gezeigten programmgesteuerten Einheit sind mit den Bezugszeichen K1, K2 und K3 bezeichnet, und die Flip-Flops der jeweiligen Flip-Flop-Ketten mit FF1-1 bis FF1-m (Flip-Flop-Kette K1), bzw. FF2-1 bis FF2-n (Flip-Flop-Kette K2), bzw. FF3-1 bis FF3-o (Flip-Flop-Kette K3).

Nach der Bildung der Flip-Flop-Ketten wird dem jeweils ersten Element der Flip-Flop-Ketten eine zufällige oder fest vorgegebene Datenfolge zugeführt. Die den Flip-Flop-Ketten zugeführten Datenfolgen werden durch die Flip-Flop-Ketten durchgeschoben. Die Flip-Flop-Ketten sind nämlich letztlich nichts anderes als Schieberegister: an das erste Element der jeweiligen Flip-Flop-Ketten angelegte Daten werden im Takt des von der programmgesteuerten Einheit verwendeten Systemtaktes von Flip-Flop zu Flip-Flop weitergeschoben.

Durch das Weiterschieben der den Flip-Flop-Ketten zugeführten Daten durch die Flip-Flop-Ketten finden in den Flip-Flops der Flip-Flop-Ketten Schaltvorgänge statt. Als Folge hiervon finden auch in den anderen Komponenten der programmgesteuerten Einheit, die die Ausgangssignale der Flip-Flops oder von den Ausgangssignalen der Flip-Flops abhängende Signale als Eingangssignale zugeführt bekommen, Schaltvorgänge statt. Insgesamt findet dadurch in der programmgesteuerten Einheit innerhalb kürzester Zeit eine sehr große Anzahl von Schaltvorgängen statt.

Die Flip-Flop-Ketten K1, K2, und K3 können, müssen aber nicht identisch mit den Scan-Ketten sein, unter Verwendung welcher die programmgesteuerte Einheit vor und/oder nach der Burn-In-Prozedur getestet werden kann.

Wenn die Flip-Flop-Ketten K1, K2, und K3 identisch mit den Scan-Ketten sind, können die diesen zuzuführenden Daten über die Pins oder Pads der programmgesteuerten Einheit, mit welchen die Eingangsanschlüsse der jeweils ersten Flip-Flop-Ketten-Elemente verbunden sind, von einem außerhalb der programmgesteuerten Einheit vorgesehenen externen Testgerät zugeführt werden; die besagten Pins sind in der Figur 1 mit den Bezugszeichen SI1, SI2, und SI3 bezeichnet; die Pins SO1, SO2, und SO3, mit welchen die Ausgangsanschlüsse der jeweils letzten Flip-Flop-Ketten-Elemente verbunden sind, müssen keine Verbindung zum externen Testgerät aufweisen, weil während der Burn-In-Prozedur kein Test der programmgesteuerten Einheit erfolgt, sondern nur eine Vorbereitung auf einen danach durchzuführenden Test.

Die den Flip-Flop-Ketten zuzuführenden Daten können aber auch durch einen oder mehrere Zufallsgeneratoren generiert werden, die in der programmgesteuerten Einheit vorgesehen sind. Von dieser Möglichkeit wird bei der in der Figur 1 gezeigten programmgesteuerten Einheit Gebrauch gemacht. Dies ist sowohl bei Flip-Flop-Ketten, die identisch mit den Scan-Ketten der programmgesteuerten Einheit sind, als auch bei anderen Flip-Flop-Ketten möglich.

Die in der Figur 1 gezeigte programmgesteuerte Einheit weist drei Zufallsgeneratoren ZG1, ZG2, und ZG3 auf. Die Ausgangsanschlüsse dieser Zufallsgeneratoren können über Umschalter S1, S2, bzw. S3 mit den Eingangsanschlüssen der jeweils ersten Flip-Flop-Ketten-Elemente verbunden werden, wobei
- durch den dem Eingangsanschluß des ersten Flip-Flops FF1-1 der Flip-Flop-Kette K1 vorgeschalteten Umschalter S1 einstellbar ist, ob der Eingangsanschluß des Flip-Flops FF1-1 mit dem Pin SI1 der programmgesteuerten Einheit oder mit dem Ausgangsanschluß des Zufallsgenerators ZG1 verbunden wird,
- durch den dem Eingangsanschluß des ersten Flip-Flops FF2-1 der Flip-Flop-Kette K2 vorgeschalteten Umschalter S2 einstellbar ist, ob der Eingangsanschluß des Flip-Flops FF2-1 mit dem Pin SI2 der programmgesteuerten Einheit oder mit dem Ausgangsanschluß des Zufallsgenerators ZG2 verbunden wird, und
- durch den dem Eingangsanschluß des ersten Flip-Flops FF3-1 der Flip-Flop-Kette K3 vorgeschalteten Umschalter S3 einstellbar ist, ob der Eingangsanschluß des Flip-Flops FF3-1 mit dem Pin SI3 der programmgesteuerten Einheit oder mit dem Ausgangsanschluß des Zufallsgenerators ZG3 verbunden wird.

Das Umschalten der Umschalter S1, S2, und S3 erfolgt auf Veranlassung durch das Burn-In-Programm im wesentlichen zeitgleich mit der Bildung der Flip-Flop-Ketten.

Die Zufallsgeneratoren werden im betrachteten Beispiel durch sogenannte Linear Feedback Shift Register (LFSRs) gebildet. Es können aber auch anders realisierte Zufallsgeneratoren zum Einsatz kommen.

Es ist auch nicht unbedingt erforderlich, daß für jede Flip-Flop-Kette ein eigener Zufallsgenerator vorgesehen wird. Es könnte beispielsweise vorgesehen werden, nur für die Flip-Flop-Kette K1 einen Zufallsgenerator vorzusehen, und die den anderen Flip-Flop-Ketten zugeführten Daten durch eine logische Verknüpfung der von diesem Zufallsgenerator generierten Daten mit an bestimmten anderen Punkten der programmgesteuerten Einheit abgegriffenen, zeitlich variierenden Signalen zu erzeugen.

Unabhängig von der Art und Weise, auf welche die durch die Flip-Flop-Ketten hindurchzuschiebenden Daten erzeugt und den Flip-Flop-Ketten zugeführt werden, werden den Flip-Flop-Ketten vorzugsweise nicht zeitgleich die selben Datenfolgen oder einen komplementären Verlauf aufweisende Datenfolgen zugeführt.

Wie vorstehend bereits erläutert wurde, können die Flip-Flops der programmgesteuerten Einheit durch das Burn-In-Programm auch zu einen oder mehreren Flip-Flop-Ringen verschaltet werden.

Der Einfachheit halber besteht jeder dieser Flip-Flop-Ringe aus einer oder mehreren Scan-Ketten, die zu einem Ring verschaltet sind. Es sei jedoch bereits an dieser Stelle darauf hingewiesen, daß hierauf keine Einschränkung besteht. Prinzipiell können die Flip-Flop-Ringe auch gänzlich unabhängig von den Scan-Ketten gebildet werden, die während des Testens der programmgesteuerten Einheit verwendet werden.

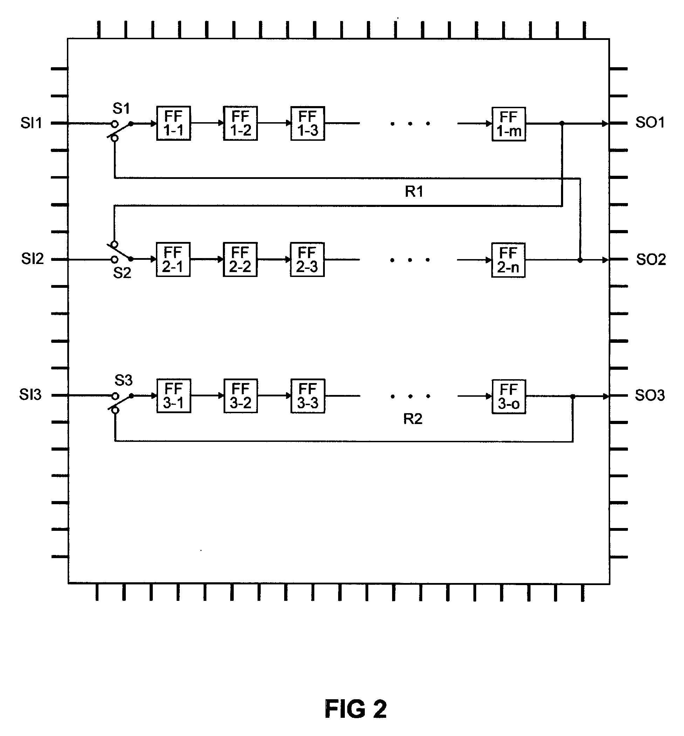

Eine programmgesteuerte Einheit deren Flip-Flops zu zwei Flip-Flop-Ringen verschaltet sind, ist in Figur 2 dargestellt. Der Vollständigkeit sei bereits an dieser Stelle darauf hingewiesen, daß auf die Zahl zwei keine Einschränkung besteht; prinzipiell kann die Anzahl der gebildeten Flip-Flop-Ringe auch beliebige andere Werte annehmen.

Die Flip-Flop-Ringe der in der Figur 2 gezeigten programmgesteuerten Einheit sind mit den Bezugszeichen R1, und R2 bezeichnet, wobei die Flip-Flops des ersten Flip-Flop-Ringes die Flip-Flops FF1-1 bis FF1-m der ersten Flip-Flop-Kette K1 gemäß Figur 1 un die Flip-Flops FF2-1 bis FF2-n der zweiten Flip-Flop-Kette K2 gemäß Figur 1 umfassen, und wobei die Flip-Flops des zweiten Flip-Flop-Ringes R2 die Flip-Flops FF3-1 bis FF3-o der dritten Flip-Flop-Kette K3 gemäß Figur 1 umfassen.

D.h., der erste Flip-Flop-Ring R1 enthält die Flip-Flop-Ketten K1 und K2 gemäß Figur 1 (die durch die Flip-Flop-Ketten K1 und K2 gebildeten Scan-Ketten), und der zweite Flip-Flop-Ring R2 enthält die Flip-Flop-Kette K3 gemäß Figur 1 (die durch die Flip-Flop-Kette K3 gebildete Scan-Kette), wobei
- der Ausgangsanschluß des letzten Flip-Flops FF1-m der Flip-Flop-Kette K1 mit dem Eingangsanschluß des ersten Flip-Flops FF2-1 der Flip-Flop-Kette K2, sowie der Ausgangsanschluß des letzten Flip-Flops FF2-n der Flip-Flop-Kette K2 mit dem Eingangsanschluß des ersten Flip-Flops FF1-1 der Flip-Flop-Kette K1 miteinander verbunden sind, und
- der Ausgangsanschluß des letzten Flip-Flops FF3-o der Flip-Flop-Kette K3 mit dem Eingangsanschluß des ersten Flip-Flops FF3-1 der Flip-Flop-Kette K3 miteinander verbunden ist.

Die genannten Verbindungen erfolgen über Umschalter S4, S5 und S6, welche den Eingangsanschlüssen der jeweils ersten Flip-Flops FF1-1, FF2-1, und FF3-1 der Flip-Flop-Ketten K1, K2 und K3 vorgeschaltet sind, und von welchen
- durch den Umschalter S4 einstellbar ist, ob der Eingangsanschluß des ersten Flip-Flops FF1-1 der Flip-Flop-Kette K1 mit dem Pin SI1 der programmgesteuerten Einheit oder mit dem Ausgangsanschluß des Flip-Flops FF2-n der Flip-Flop-Kette K2 verbunden wird,
- durch den Umschalter S5 einstellbar ist, ob der Eingangsanschluß des ersten Flip-Flops FF2-1 der Flip-Flop-Kette K2 mit dem Pin SI2 der programmgesteuerten Einheit oder mit dem Ausgangsanschluß des Flip-Flops FF1-m der Flip-Flop-Kette K1 verbunden wird, und
- durch den Umschalter S6 einstellbar ist, ob der Eingangsanschluß des ersten Flip-Flops FF3-1 der Flip-Flop-Kette K3 mit dem Pin SI3 der programmgesteuerten Einheit oder mit dem Ausgangsanschluß des letzten Flip-Flops FF3-o der Flip-Flop-Kette K3 verbunden wird.

Das Umschalten der Umschalter S4, S5, und S6 erfolgt auf Veranlassung durch das Burn-In-Programm im wesentlichen zeitgleich mit der Bildung der Flip-Flop-Ringe.

Nach der Bildung der Flip-Flop-Ringe werden die Daten, die zum Zeitpunkt der Flip-Flop-Ring-Bildung in den Flip-Flops gespeichert sind, im Takt des von der programmgesteuerten Einheit verwendeten Systemtaktes von Flip-Flop zu Flip-Flop im Kreis weitergeschoben.

Durch das Weiterschieben der Daten finden in den Flip-Flops der Flip-Flop-Ringe Schaltvorgänge statt. Als Folge hiervon finden auch in den anderen Komponenten der programmgesteuerten Einheit, die die Ausgangssignale der Flip-Flops oder von den Ausgangssignalen der Flip-Flops abhängende Signale als Eingangssignale zugeführt bekommen, Schaltvorgänge statt. Insgesamt findet dadurch in der programmgesteuerten Einheit innerhalb kürzester Zeit eine sehr große Anzahl von Schaltvorgängen statt.

Insbesondere dann, wenn die Flip-Flop-Ringe R1 und R2 unterschiedlich viele Flip-Flops enthalten, d.h., wenn m+n ≠ o gilt, kann darauf verzichtet werden, von einem Zufallsgenerator erzeugte Daten in die Flip-Flop-Ringe einzuspeisen. Dies liegt daran, weil es sehr lange, genauer gesagt (m+n)*o Taktzyklen dauert, bis alle Flip-Flops wieder den selben Inhalt haben, und sich die in der programmgesteuerten Einheit ablaufenden Vorgänge wiederholen.

Unabhängig hiervon können in die Flip-Flop-Ringe R1 und/oder R2 Daten eingeschleust werden bzw. die weitergeschobenen Daten verändert werden. Dies kann beispielsweise dadurch geschehen, daß zwischen zwei Flip-Flops eine oder mehrere logische Gatter eingefügt werden, deren Eingangsanschlüsse mit den Ausgangsanschlüssen einer oder mehrerer beliebiger Flip-Flops (auch mit den Ausgangsanschlüssen von Flip-Flops, die Bestandteil anderer Flip-Flop-Ringe sind), und/oder mit bestimmten anderen Punkten der programmgesteuerten Einheit, an welchen sich zeitlich variierende Signalen einstellen, verbunden werden.

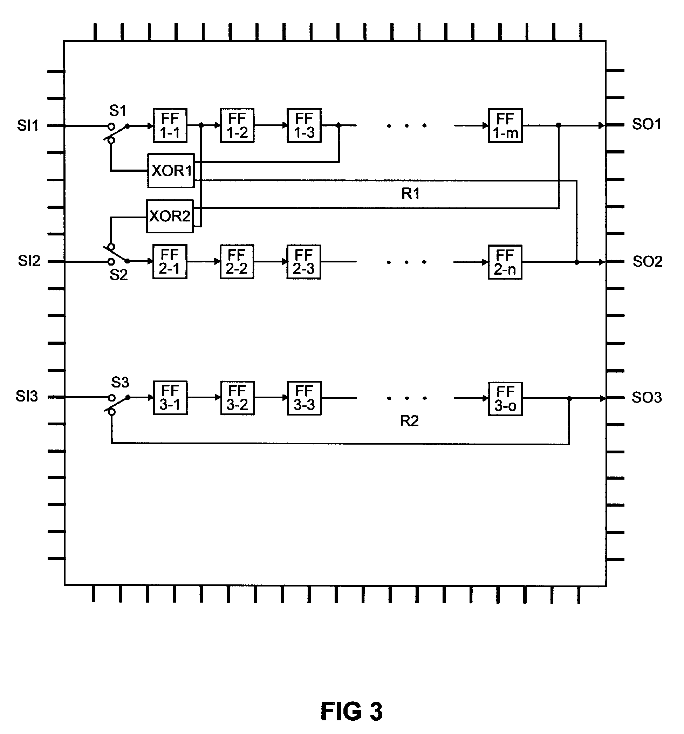

Ein Beispiel hierfür ist in Figur 3 dargestellt. Die Figur 3 zeigt eine programmgesteuerte Einheit, deren Flip-Flops zu zwei Flip-Flop-Ringen verschaltet sind. Diese programmgesteuerte Einheit entspricht abgesehen von den im folgenden beschriebenen Besonderheiten vollständig der in der Figur 2 gezeigten programmgesteuerten Einheit; mit den selben Bezugszeichen bezeichnete Elemente bezeichnen identische oder einander entsprechende Elemente.

Die Besonderheit der in der Figur 3 gezeigten programmgesteuerten Einheit bestehen darin, daß der erste Flip-Flop-Ketten-Ring R1 zusätzliche Elemente, genauer gesagt zwei mit den Bezugszeichen XOR1 und XOR2 bezeichnete EXOR-Gatter enthält,
- wobei das EXOR-Gatter XOR1 zwischen dem letzten Flip-Flop FF2-n der zweiten Flip-Flop-Kette K2 und dem Umschalter S4 angeordnet ist, und als Eingangssignale das Ausgangssignal des Flip-Flops FF2-n und das Ausgangssignal des Flip-Flops FF1-3 erhält, und
- wobei das EXOR-Gatter XOR2 zwischen dem letzten Flip-Flop FF1-m der ersten Flip-Flop-Kette K1 und dem Umschalter S5 angeordnet ist, und als Eingangssignale das Ausgangssignal des Flip-Flops FF1-m und das Ausgangssignal des Flip-Flops FF1-1 enthält.

Durch das Einfügen der EXOR-Gatter XOR1 und XOR2 bildet der Flip-Flop-Ring R1 selbst einen Zufallsgenerator, genauer gesagt selbst ein LFSR.

Durch den Einbau der EXOR-Gatter oder anderer logischer Gatter in die Flip-Flop-Ringe wird erreicht, daß die durch die Flip-Flop-Ringe geschobenen Daten auf bestimmte Weise oder zufällig verändert werden.

EXOR-Gatter oder sonstige logische Gatter können auch in die Flip-Flop-Ketten gemäß Figur 1 eingebaut werden, um die durch die Flip-Flop-Ketten geschobenen Daten auf bestimmte Weise oder zufällig zu verändern.

Eine Veränderung der durch die Flip-Flop-Ketten oder die Flip-Flop-Ringe geschobenen Daten kann auch dadurch erreicht werden, daß (vorzugsweise in unregelmäßigen zeitlichen Abständen) anstelle eines Schiebezyklus ein sogenannter capture cycle durchgeführt wird. Bei einem solchen capture cycle wird die Reihenschaltung der Flip-Flops für einen oder mehrere Takte aufgelöst, wodurch die Flip-Flops wieder so betrieben werden wie es während des normalen Betriebes der programmgesteuerten Einheit der Fall ist. Die Auflösung der Flip-Flop-Ketten bzw. Flip-Flop-Ringe erfolgt durch ein Umschalten der vorstehend bereits erwähnten, in den Figuren nicht gezeigten Umschalter, die den Eingangsanschlüssen der Flip-Flops vorgeschaltet sind, und die durch das Burn-In-Programm zur Bildung der Flip-Flop-Ketten bzw. der Flip-Flop-Ringe umgeschaltet wurden. Die nach dem Auflösen der Flip-Flop-Ketten oder Flip-Flop-Ringe von den Flip-Flops übernommenen Daten sind nicht oder jedenfalls größtenteils nicht die von anderen Flip-Flops ausgegebenen Daten, sondern durch andere Komponenten der programmgesteuerten Einheit generierte Daten. Schaltet man die Flip-Flops anschließend wieder zu Flip-Flop-Ketten oder Flip-Flop-Ringen zusammen, so haben die Flip-Flops derselben einen anderen Inhalt als es vor der Auflösung der Flip-Flop-Ketten bzw. der Flip-Flop-Ringe der Fall war. Das nach der Wiederherstellung der Flip-Flop-Ketten bzw. Flip-Flop-Ringe wieder einsetzende Weiterschieben der in den Flip-Flops gespeicherten Daten löst in der programmgesteuerten Einheit folglich andere Operationen aus als es vorher der Fall war. Die Einfügung eines solchen capture cycle kann für einzelne, mehrere oder alle Flip-Flop-Ketten oder Flip-Flop-Ringe erfolgen.

Eine Veränderung der durch die Flip-Flop-Ketten oder die Flip-Flop-Ringe geschobenen Daten kann auch dadurch erreicht werden, daß (vorzugsweise in unregelmäßigen zeitlichen Abständen) Teile der programmgesteuerten Einheit, zurückgesetzt werden. Dadurch können die Flip-Flops des jeweils zurückgesetzten Teils der programmgesteuerten Einheit, und zwar nur diese, einen anderen Wert zugewiesen bekommen.

Eine Veränderung der durch die Flip-Flop-Ketten oder die Flip-Flop-Ringe geschobenen Daten kann auch dadurch erreicht werden, daß das die Flip-Flops zu Flip-Flop-Ketten oder Flip-Flop-Ringen verschaltende Burn-In-Programm dafür sorgt, daß die Flip-Flops zu dem Zeitpunkt, zu welchen sie zu Flip-Flop-Ketten oder Flip-Flop-Ringen verschaltet werden, nicht immer die selben Inhalte aufweisen. Dies kann beispielsweise dadurch bewerkstelligt werden, daß dafür gesorgt wird, daß das Burn-In-Programm nicht immer in gleicher Weise abläuft, sondern die auszuführenden Operationen in unterschiedlicher Reihenfolge ausführt, und/oder abwechselnd bestimmte Operationen nicht ausführt, und/oder bestimmte oder alle Register zu unterschiedlichen Zeitpunkten und/oder mit unterschiedlichen Daten beschreibt. Dadurch kann erreicht werden, daß sich die programmgesteuerte Einheit zu den Zeitpunkten, zu welchem das Burn-In-Programm die Flip-Flops zu Flip-Flop-Ketten oder Flip-Flop-Ringen verschaltet, jeweils in unterschiedlichen Zuständen befindet, und folglich auch die Flip-Flops jeweils andere Inhalte aufweisen.

Daß das Burn-In-Programm nicht immer in gleicher Weise abläuft, kann beispielsweise dadurch erreicht werden, daß das Burn-In-Programm vor dem Verschalten der Flip-Flops zu Flip-Flop-Ketten oder Flip-Flop-Ringen Daten speichert, die durch ein Rücksetzen der programmgesteuerten Einheit und/oder durch ein Ausschalten der programmgesteuerten Einheit nicht gelöscht werden, und daß der Ablauf des Burn-In-Programms beim nächsten Start desselben von diesen Daten abhängig gemacht wird.

Eine gewisse Zeit nach der Bildung der Flip-Flop-Ketten bzw. Flip-Flop-Ringe werden diese wieder aufgelöst, und wird wieder das Burn-In-Programm gestartet. Dabei wiederholen sich die vorstehend beschriebenen Vorgänge.

Die Stimulation der integrierten Schaltung durch das Burn-In-Programm, und die Stimulation der integrierten Schaltung durch das Weiterschieben von Daten innerhalb der Flip-Flop-Ketten bzw. Flip-Flop-Ringe werden vorzugsweise während der gesamten Burn-In-Prozedur pausenlos abwechselnd ausgeführt.

Wie eingangs bereits erwähnt wurde, muß die integrierte Schaltung keine programmgesteuerte Einheit sein. Wenn die integrierte Schaltung keine programmgesteuerte Einheit ist, können die Funktionen, die im vorstehend beschriebenen Beispiel durch die CPU und das auf dieser ausgeführte Burn-In-Programm wahrgenommen werden, durch eine andere Steuereinrichtung wie beispielsweise eine state machine übernommen werden.

Unabhängig hiervon kann sich die beschriebene integrierte Schaltung auch als vorteilhaft erweisen, wenn die Bildung der Flip-Flop-Ketten oder der Flip-Flop-Ringe nicht durch eine interne Steuereinrichtung wie eine CPU oder eine state machine, sondern von außerhalb der integrierten Schaltung veranlaßt wird.

Durch die beschriebene integrierte Schaltung ist es unabhängig von den Einzelheiten der praktischen Realisierung möglich, den Aufwand zur Durchführung der Burn-In-Prozedur zu reduzieren.

### Bezugszeichenliste

- FFx: Flip-Flop
- Kx: Flip-Flop-Ketten
- Rx: Flip-Flop-Ringe
- Sx: Schalter
- SIx: Eingangsanschlüsse
- SOx: Ausgangsanschlüsse
- XORx: EXOR-Gatter
- ZGx: Zufallsgenerator

## Patentansprüche

1. Integrierte Schaltung,
**dadurch gekennzeichnet,**
**daß** in der integrierten Schaltung enthaltene Flip-Flops, welche im normalen Betrieb der integrierten Schaltung nicht in Reihe geschaltet sind, auf Veranlassung durch die integrierte Schaltung in Reihe schaltbar sind.

2. Integrierte Schaltung nach Anspruch 1,
**dadurch gekennzeichnet,**
**daß** die Flip-Flops zu einer oder mehreren Flip-Flop-Ketten verschaltet werden.

3. Integrierte Schaltung nach Anspruch 2,
**dadurch gekennzeichnet,**
**daß** jede Flip-Flop-Kette eine oder mehreren Scan-Ketten umfaßt, unter Verwendung welcher die integrierte Schaltung getestet werden kann.

4. Integrierte Schaltung nach Anspruch 1,
**dadurch gekennzeichnet,**
**daß** die Flip-Flops zu einem oder mehreren Flip-Flop-Ringen verschaltet werden.

5. Integrierte Schaltung,
**dadurch gekennzeichnet,**
**daß** in der integrierten Schaltung enthaltene Flip-Flops zu einem oder mehreren Ringen verschaltbar sind.

6. Integrierte Schaltung nach Anspruch 4 oder 5,
**dadurch gekennzeichnet,**
**daß** jeder Flip-Flop-Ring eine oder mehreren Scan-Ketten umfaßt, unter Verwendung welcher die integrierte Schaltung getestet werden kann.

7. Integrierte Schaltung nach einem der Ansprüche 2, 4 und 5,
**dadurch gekennzeichnet,**
**daß** dann, wenn mehrere Flip-Flop-Ketten oder Flip-Flop-Ringe gebildet werden, die mehreren Flip-Flop-Ketten oder Flip-Flop-Ringe zumindest teilweise unterschiedlich viele Flip-Flops umfassen.

8. Integrierte Schaltung nach einem der vorhergehenden Ansprüche,
**dadurch gekennzeichnet,**
**daß** die integrierte Schaltung eine synchrone digitale Schaltung ist.

9. Integrierte Schaltung nach einem der vorhergehenden Ansprüche,
**dadurch gekennzeichnet,**
**daß** das Verschalten der Flip-Flops zu Flip-Flop-Ketten oder Flip-Flop-Ringen während einer Burn-In-Prozedur durchgeführt wird, während welcher versucht wird, möglichst viele Elemente der integrierten Schaltung möglichst oft schalten zu lassen.

10. Integrierte Schaltung nach einem der vorhergehenden Ansprüche,
**dadurch gekennzeichnet,**
**daß** die integrierte Schaltung eine Steuereinrichtung enthält, und daß die Steuereinrichtung die Verschaltung der Flip-Flops zu Flip-Flop-Ketten oder Flip-Flop-Ringen veranlaßt.

11. Integrierte Schaltung nach Anspruch 10,
**dadurch gekennzeichnet,**
**daß** die Steuereinrichtung vor der Verschaltung der Flip-Flops zu Flip-Flop-Ketten oder Flip-Flop-Ringen, ausgewählte oder alle anderen Komponenten der integrierten Schaltung so ansteuert, daß in diesen möglichst viele Schaltvorgänge stattfinden.

12. Integrierte Schaltung nach einem der vorhergehenden Ansprüche,
**dadurch gekennzeichnet,**
**daß** die Flip-Flops nach deren Verschaltung zu Flip-Flop-Ketten oder Flip-Flop-Ringen die in ihnen gespeicherten Daten an das jeweils nach ihnen angeordnete Flip-Flop weiterleiten, und gleichzeitig die ihnen vom jeweils vor ihnen angeordneten Flip-Flop zugeführten Daten übernehmen.

13. Integrierte Schaltung nach Anspruch 12,
**dadurch gekennzeichnet,**
**daß** die Übernahme und die Weiterleitung von Daten im Takt eines innerhalb der integrierten Schaltung erzeugten Taktsignals erfolgt.

14. Integrierte Schaltung nach einem der vorhergehenden Ansprüche,
**dadurch gekennzeichnet,**
**daß** die integrierte Schaltung einen Zufallsgenerator enthält, und daß die von diesem Zufallsgenerator generierten Daten in die Flip-Flop-Ketten oder die Flip-Flop-Ringe eingespeist werden.

15. Integrierte Schaltung nach einem der vorhergehenden Ansprüche,
**dadurch gekennzeichnet,**
**daß** die Flip-Flop-Ketten oder die Flip-Flop-Ringe zumindest teilweise ein zwischen zwei Flip-Flops angeordnetes logisches Gatter enthalten, welches in der integrierten Schaltung generierte Signale einer logischen Verknüpfung unterzieht und das Ergebnis der Verknüpfung an das nach ihm angeordnete Flip-Flop weiterleitet.

16. Integrierte Schaltung nach einem der vorhergehenden Ansprüche,
**dadurch gekennzeichnet,**
**daß** die integrierte Schaltung die Flip-Flop-Ketten oder Flip-Flop-Ringe zumindest teilweise in gewissen zeitlichen Abständen vorübergehend auflöst.

17. Integrierte Schaltung nach einem der vorhergehenden Ansprüche,
**dadurch gekennzeichnet,**
**daß** die integrierte Schaltung nach der Verschaltung der Flip-Flops zu Flip-Flop-Ketten oder Flip-Flop-Ringen in gewissen zeitlichen Abständen Teile der integrierten Schaltung zurücksetzt.

18. Integrierte Schaltung nach Anspruch 16 oder 17,
**dadurch gekennzeichnet,**
**daß** die zeitlichen Abstände unregelmäßige zeitliche Abstände sind.

19. Integrierte Schaltung nach einem der vorhergehenden Ansprüche,
**dadurch gekennzeichnet,**
**daß** die integrierte Schaltung die Reihenfolge und/oder die Art und/oder den Umfang der Operationen, die die integrierte Schaltung vor der Verschaltung der Flip-Flops zu Flip-Flop-Ketten oder Flip-Flop-Ringen ausführt, variiert, um wechselnde Startbedingungen für die in den Flip-Flop-Ketten oder Flip-Flop-Ringen erfolgenden Schiebeoperationen zu schaffen.

20. Integrierte Schaltung nach Anspruch 10,
**dadurch gekennzeichnet,**
**daß** die integrierte Schaltung eine programmgesteuerte Einheit ist, und daß die Steuereinrichtung die CPU der programmgesteuerten Einheit ist.

21. Integrierte Schaltung nach einem der Ansprüche 1 bis 19,
**dadurch gekennzeichnet,**
**daß** die Steuereinrichtung eine state machine ist.
